# EUROPEAN PATENT APPLICATION

(11) **EP 4 800 412 A1**
(43) Date of publication of application: **02.09.2026**
(21) Application number: 25864620.7
(22) Date of filing: 05.09.2025
(51) Int. Cl.: G01R 31/52, G01R 19/12, G01R 19/10, G01R 31/385, H04N 5/33, G01R 19/165

(54) **BATTERY MANAGEMENT APPARATUS AND BATTERY MANAGEMENT METHOD**

(30) Priority: 23.12.2024 KR 20240194163
(71) Applicant: LG ENERGY SOLUTION, LTD., Seoul 07335 (KR)
(72) Inventor: LEE, Seung Hyuk, Daejeon 34122 (KR)
(74) Representative: Goddar, Heinz J.
(86) International application number: PCT/KR2025/013818
(87) International publication number: WO 2026/141846

(57) **Abstract**

According to some embodiments, a battery management device includes: an interface configured to obtain an open- circuit voltage (OCV) value of each of battery cells of a battery; and a controller configured to calculate an OCV difference value representing a change amount of the OCV value of each battery cell during a reference period, to set a classification reference value based on a distribution of the OCV difference values of the battery cells, and to classify states of the battery cells based on the classification reference value.

## Description

### TECHNICAL FIELD

### Cross-Reference to Related Applications

This application claims priority to and the benefit of Korean Patent Application No. 10-2024-0194163, filed on December 23, 2024, the disclosure of which is incorporated herein by reference in its entirety.

### Technical Field

The embodiments disclosed in this document relate to a battery management device and a battery management method.

### BACKGROUND ART

Recently, research and development on secondary batteries has been actively conducted. Here, a secondary battery is a rechargeable battery, and may be interpreted as encompassing both conventional Ni/Cd batteries, Ni/MH batteries, and the like, as well as recent lithium-ion batteries. Among secondary batteries, lithium-ion batteries may have higher energy density compared to conventional Ni/Cd batteries, Ni/MH batteries, and the like, and may be manufactured to be compact and lightweight, thereby having high utility for power sources of mobile devices. Recently, their use has expanded to power sources for electric vehicles, drawing attention as next-generation energy storage media.

The presence of foreign matter inside a battery cell may cause micro-short circuits, which may lead to a low-voltage phenomenon where the cell voltage abnormally decreases. Method of tracking open-circuit voltage (OCV) may be used to identify low-voltage cells, and criteria for fault diagnosis may be established in a statistical manner. In the vicinity of statistically established diagnostic criteria, false negatives may occur where defective cells are incorrectly identified as normal, and false positives may occur where normal cells are incorrectly identified as defective, and it may be necessary to address these issues to improve diagnostic reliability.

### DISCLOSURE

### TECHNICAL PROBLEM

One of the objects of the embodiments disclosed in this document is to provide a battery management device and a battery management method capable of diagnosing cell conditions such as micro-short circuits based on the distribution of changes in open-circuit voltage (OCV) values of each cell over a predetermined period.

The technical objects of the embodiments disclosed in this document are not limited to the above-mentioned technical problems, and other technical problems that are not mentioned will be clearly understood by those skilled in the art from the following description.

### TECHNICAL SOLUTION

According to some embodiments, a battery management device includes: an interface configured to obtain an open circuit voltage (OCV) value of each of the battery cells of the battery; and a controller configured to calculate an OCV difference value representing a change in the OCV value of each battery cell during a reference period, set a classification reference value based on a distribution of the OCV difference values of the battery cells, and classify a state of the battery cells based on the classification reference value.

According to some embodiments, the controller is configured to select a characteristic point based on variation of an OCV difference value slope in the distribution of the OCV difference values, and to set the OCV difference value corresponding to the characteristic point as the classification reference value.

According to some embodiments, wherein the characteristic point includes an inflection point where a sign of a slope of the OCV difference value changes from positive to negative or from negative to positive.

According to some embodiments, the distribution of the OCV difference values includes a log-logistic distribution of the OCV difference values.

According to some embodiments, the controller is configured to perform a thermal test on reclassification cells among the battery cells that belong to a reclassification range including the classification reference value and to classify a state of the reclassification cells based on a result of the thermal test.

According to some embodiments, the battery management device further includes: a charge/discharge unit configured to apply a charge/discharge current to the reclassification cells; and an imaging unit configured to capture thermal images of the reclassification cells while the charge/discharge current is applied.

According to some embodiments, the controller is configured to diagnose a state of a reclassification cell among the reclassification cells in which a heat spot is detected in the thermal image as a faulty state.

According to some embodiments, the controller is configured to perform the thermal test on false positive (FP) suspected cells among the battery cells that belong to a range between a lower limit value of the reclassification range and the classification reference value.

According to some embodiments, a battery management method includes: a step of obtaining an open-circuit voltage (OCV) value of each of battery cells of a battery; a step of calculating an OCV difference value representing a change amount of the OCV value of each battery cell during a reference period; a step of setting a classification reference value based on a distribution of the OCV difference value of the battery cells; and a step of classifying states of the battery cells based on the classification reference value.

According to some embodiments, the step of setting the classification reference value includes: a step of selecting a characteristic point based on variation of an OCV difference value slope in the distribution of the OCV difference values; and a step of setting an OCV difference value corresponding to the characteristic point as the classification reference value.

According to some embodiments, the characteristic point includes an inflection point where a sign of a slope of the OCV difference value changes from positive to negative or from negative to positive.

According to some embodiments, the distribution of the OCV difference values includes a log-logistic distribution of the OCV difference values.

According to some embodiments, the battery management method further includes: a step of performing a thermal test on reclassification cells among the battery cells that belong to a reclassification range including the classification reference value; and a step of classifying a state of the reclassification cells based on a result of the thermal test

According to some embodiments, the step of performing the thermal test includes: a step of applying a charge/discharge current to the reclassification cells through a charge/discharge unit; and a step of capturing thermal images of the reclassification cells through an imaging unit while the charge-discharge current is applied

According to some embodiments, the step of classifying the state of the reclassification cells includes a step of diagnosing a state of a reclassified cell among the reclassification cells in which a heat spot is detected in the thermal image as a faulty state.

According to some embodiments, the step of performing the thermal test includes a step of performing the thermal test on false positive (FP) suspected cells among the battery cells that belong to a range between a lower limit value of the reclassification range and the classification reference value

### ADVANTAGEOUS EFFECTS

According to embodiments disclosed in this document, a battery management device and a battery management method can be provided that can diagnose cell states such as micro-short circuits based on the distribution of changes in the open-circuit voltage (OCV) value of each cell over a predetermined period of time.

The technical effects of the embodiments disclosed in this document are not limited to the above-mentioned effects, and other effects that are not mentioned will be clearly understood by those skilled in the art in accordance with the disclosure of this document.

### DESCRIPTION OF DRAWINGS

FIG. 1 illustrates components of a battery system according to some embodiments.
FIG. 2 illustrates components of a battery management device according to some embodiments.
FIG. 3 illustrates a process of reclassifying reclassification cells located in the vicinity of a classification reference value based on a thermal test according to some embodiments.
FIG. 4 illustrates a battery management device according to some embodiments which includes a charge/discharge unit and an imaging unit.
FIG. 5 illustrates a method for classifying states of battery cells using a classification reference value that is set based on a distribution of open-circuit voltage (OCV) difference values according to some embodiments.
FIG. 6 illustrates steps of configuring a battery management method according to some embodiments.

### Modes of the Invention

Hereinafter, the embodiments described in this document are described with reference to the attached drawings. However, this is not intended to limit the disclosure of this document to a particular embodiment, and should be understood to include various modifications, equivalents, and/or alternatives of the embodiments described in this document.

The embodiments in this document and the terms used herein are not intended to limit the technical features described in this document to a particular embodiment, and should be understood to include various modifications, equivalents, or alternatives of the embodiment. Regarding the description of the drawings, similar reference symbols may be used for similar or related components. The singular form of a noun corresponding to an item may include one or more of the items unless explicitly indicated otherwise in the relevant context.

In this document, each of the phrases such as "A or B," "at least one of A and B," "at least one of A or B," "A, B, or C," "at least one of A, B, and C", and "at least one of A, B, or C" may include any one of the items listed together in the corresponding phrase, or all possible combinations thereof. Terms such as "first," "second, "A," "B," "(a)," or "(b)" may be used merely to distinguish one component from another, and do not limit the components in any other respect (e.g., importance or sequence) unless specifically stated otherwise.

In this document, when a component (e.g., 1) is referred to as "coupled," "combined" or "connected" to another component (e.g., 2), with or without the term "functionally" or "communicatively," it means that the component may be connected to the other component directly (e.g., wired or wirelessly), or indirectly (e.g., through a third component).

The method according to various embodiments disclosed in this document may be provided as a computer program product. The computer program product may be traded between sellers and buyers as a commodity. The computer program product may be distributed in the form of a device-readable storage medium (e.g., compact disc read only memory, CD-ROM), or distributed via an application store or between two driver devices, either directly or online (e.g., download or upload). In the case of online distribution, at least part of the computer program product may be stored temporarily on a device-readable storage medium such as the manufacturer's server, the server of the application store, or the memory of a proxy server, or may be temporarily generated.

According to an embodiment disclosed in this document, each of the above-described components (e.g., module or program) may include a single object or a plurality of objects, and some of the plurality of objects may be placed separately in other components. According to an embodiment disclosed in the present invention, one or more of the above-described components or operations may be omitted, or one or more other components or operations may be added. Alternatively or additionally, a plurality of components (e.g., modules or programs) may be integrated into a single component. In such a case, the integrated component may perform the functions of one or more of the components of the plurality in a manner that is identical or similar to that performed by each of the components of the plurality prior to the integration. According to an embodiment disclosed in this document, operations performed by the module, program or other component may be performed sequentially, parallelly, repetitively, or heuristically, or one or more of the operations may be performed in a different order, omitted, or one or more other operations may be added.

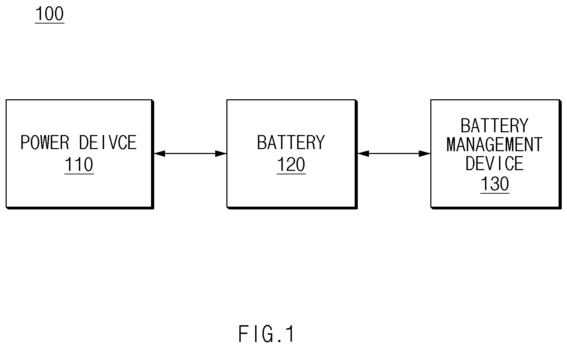

FIG. 1 illustrates components of a battery system according to some embodiments.

Referring to FIG. 1, the battery system 100 may include a power device 110, a battery 120, and a battery management device 130. However, the present invention is not limited thereto, and some components may be omitted from the battery system 100 or other general-purpose components may be further included in the battery system 100.

The power device 110 may be configured to charge or discharge a battery 120. The power device 110 may include a power consumption device and/or a power supply device. The power device 110 may discharge the battery 120 while consuming power, or charge the battery 120 while generating power. According to an embodiment, the power consumption device may include a motor for a mobility device such as an electric vehicle (EV), a hybrid electric vehicle (HEV), or an electric bicycle. The mobility device may also operate as a power supply for charging the battery 120. The mobility device may use power from the battery 120 to drive the motor or to charge the battery 120 with power generated through regenerative braking. The charger/discharger may apply a charge current, a charge voltage, a discharge current, and/or a discharge voltage to the battery 120 based on a given profile or cycle.

The battery 120 may include one or more battery packs and the like. The battery pack of the battery 120 may include a plurality of battery modules, and each battery module may include a plurality of battery cells. According to an embodiment, the battery 120 may be embedded in a variety of types of mobility devices. According to an embodiment, the battery 200 may be utilized in a battery swapping system (BSS) and/or an energy storage system (ESS).

The battery management device 130 may perform operations for diagnosing, managing, and/or controlling the battery 120. The battery management device 130 may acquire battery data of the battery 120, diagnose or manage the state of the battery 120 based on the data, and control the output or discharge of the battery 120. According to an embodiment, the battery management device 130 may include a battery management system (BMS) configured with the battery 120 in an on-board mode, and/or an external device disposed remotely from the battery 120 in an off-board mode.

The battery system 100 may further include a management server. The management server may manage the management results of the battery management device 130. The management server may exchange data with the battery management device 130 by means of wireless/wireless communication. When the battery 120 is diagnosed to be defective or its lifetime is predicted, the results may be transmitted to the management server and recorded in the database. According to an embodiment, the battery management device 130 may perform diagnostic operations by running battery management software, and the management server may provide battery management software update information to the battery management device 130.

The battery management device 130 may inspect whether defects such as internal short circuits have occurred during the manufacturing process of the battery 120, or may inspect whether defects occur in the battery 120 in real time while the battery 120 is being used in mobility devices, ESS, BSS, and the like.

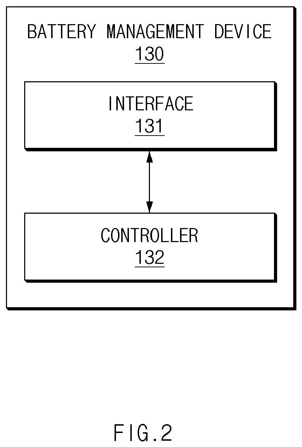

FIG. 2 illustrates components of a battery management device according to some embodiments.

Referring to FIG. 2, the battery management device 130 may include an interface 131 and a controller 132. However, the present invention is not limited thereto, and some components may be omitted from the battery management device 130, or other general-purpose components may be further included in the battery management device 130.

The interface 131 may be configured to acquire battery data of the battery 120. According to an embodiment, the interface 131 may include a communication unit configured to receive battery data and/or a sensor unit configured to measure battery data. According to an embodiment, when the battery management device 130 is implemented in an off-board form, the communication unit may receive battery data through wired data communication, wireless data communication, or the like. Alternatively, when the battery management device 130 is implemented in an on-board form, the sensor unit may be configured to measure values such as voltage, current, temperature, resistance, and the like from the battery 120. According to an embodiment, the battery data may include charging data related to charging of the battery 120 and/or discharging data related to discharging. For example, the charging data and/or discharging data may include current data, voltage data, temperature data, capacity data, resistance data, and/or degradation data.

According to an embodiment, the interface 131 may be configured to obtain open-circuit voltage (OCV) values of each of the battery cells of the battery 120. The OCV may be a voltage measured in an open state where no current flows through the battery 120. For example, when inspecting defects in the manufacturing process, OCV values of cells manufactured in the manufacturing facility may be measured, and the battery management device 130 may receive the OCV values through the interface 131 to manage cumulative values. Alternatively, when inspecting defects occurring during use in mobility devices or the like, the battery management device 130 may periodically measure OCV values of battery cells of the battery 120 mounted on the mobility device or the like directly through a sensor unit, or may periodically receive OCV measurement values through a communication unit.

The controller 132 may have a structure for executing instructions that implement operations of the battery management device 130. The controller 132 may be implemented as an array of multiple logic gates for processing various operations or as a general-purpose microprocessor, and may include a single processor or a plurality of processors. For example, the controller 132 may be implemented in the form of at least one of a microprocessor, CPU, GPU, and AP.

The controller 132 may operate with a memory configured to store various data, instructions, mobile applications, computer programs, and the like. The memory may be configured separately from or integrally with the controller 132. The controller 132 may execute instructions stored in the memory to process various operations. For example, the memory may be implemented as non-volatile devices such as ROM, PROM, EPROM, EEPROM, flash memory, PRAM, MRAM, RRAM, FRAM, and the like, or volatile devices such as DRAM, SRAM, SDRAM, PRAM, and the like, and may be implemented in the form of HDD, SSD, SD, Micro-SD, and the like, or in the form of combinations thereof.

The controller 132 may be configured to calculate an OCV difference value representing a change amount of the OCV value of each battery cell during a reference period. The reference period may be preset for calculation of the OCV difference value (dOCV). For example, when inspecting the manufacturing state after completion of manufacturing of the battery 120, or when inspecting the state of the battery 120 after termination of operation of an electric vehicle, an amount by which the OCV value varies during the reference period may be calculated to detect an amount of self-discharge. For example, the reference period may be 1 hour, 3 hours, 6 hours, 12 hours, 24 hours, 3 days, 7 days, or other appropriate period. According to an embodiment, the reference period may be newly set for each inspection based on the manufacturing environment or operating environment of the battery 120 instead of a preset fixed value. For example, the reference period for calculation of the OCV difference value (dOCV) may be determined based on operating time, operating distance, average speed, battery consumption, and the like of the electric vehicle.

The controller 132 may be configured to set a classification reference values based on the distribution of OCV difference values of the battery cells. For example, when inspecting defects during the manufacturing process, OCV difference values of manufactured cells may be cumulatively collected, and the distribution of the OCV difference values may be analyzed based on the cumulative data. When inspecting defects that occur while the battery 120 is used in mobility devices or the like, OCV difference values of the cells constituting the battery 120 may be collected. For example, OCV difference values may be collected each time operation of an electric vehicle is terminated or each time the vehicle is not operated for an extended period, and the distribution of OCV difference values may be analyzed based on data collected n times. For example, the distribution of the OCV difference values may be plotted in the form of a two-dimensional graph, curve, or the like, and classification reference values for dOCV values may be set based on characteristics appearing in the two-dimensional graph, curve, or the like.

The controller 132 may be configured to classify the states of the battery cells based on the classification reference value. For example, cells having a dOCV value exceeding the classification reference value may be classified as defective cells having internal short circuits, high self-discharge rates, low voltage phenomena, or the like, and cells having a dOCV value below the classification reference value may be classified as normal cells. Various additional actions may be performed according to the diagnosis results. For example, the battery management device 130 may provide the diagnosis results in the form of warnings or notifications to a manager of the manufacturing process, or to a user of the battery 120 and/or the power device 110. Alternatively, when the battery 120 is mounted in a mobility device or the like, the battery management device 130 may control output limitation, performance limitation, circuit opening, circuit shorting, or the like for cells classified as defective.

According to an embodiment, the controller 132 may be configured to select a characteristic point from the distribution of OCV difference values based on variation in the OCV difference value slope and to set an OCV difference value corresponding to the characteristic point as a classification reference value. For example, the characteristic point may include a point where the trend of the OCV difference value slope changes. A trend change point may be identified by comparing the amount or rate of the slope variation with a threshold value. For example, a point where an early-stage slope transitions to a later-stage slope in the distribution of OCV difference values may be identified as a characteristic point. The characteristic point may be utilized as a classification reference value for classifying whether battery cells are defective. For example, a cell having an OCV difference value (dOCV) higher than the classification reference value may be classified as a defective cell.

According to an embodiment, the characteristic point may include an inflection point where the sign of the OCV difference value slope changes from positive to negative or from negative to positive. Among various types of characteristic points, the inflection point may be utilized as a classification reference value. At the inflection point, an increasing trend of the OCV difference value slope may change to a decreasing trend, or a decreasing trend may change to an increasing trend.

According to an embodiment, the distribution of the OCV difference values may include a log-logistic distribution of the OCV difference values. For example, the distribution of OCV difference values may be analyzed in the form of various logistic distributions, among which the log-logistic distribution may be utilized. According to the logistic distribution, the OCV difference values of the battery cells may be plotted in order from 0% to 100%, and in the case of a log-logistic distribution, the logarithmic values of the OCV difference values (dOCV) may be plotted in order from 0% to 100%. When the log-logistic distribution is utilized, a characteristic point where the trend of the dOCV slope transitions may be more clearly identified.

According to an embodiment, the controller 132 may be configured to perform a thermal test on reclassification cells belonging to a reclassification range that includes the classification reference value among the battery cells, and to classify the states of the reclassification cells based on the results of the thermal test. Since the classification reference value is identified through a statistical method of confirming a change point in the slope trend through a log-logistic distribution or the like, a classification error may occur in the vicinity of the classification reference value. A thermal test may be performed to re-examine whether cells vulnerable to classification errors are defective. The thermal test may examine whether thermal spots formed at micro short-circuit sites inside the cells are detected.

According to an embodiment, the battery management device 130 may further include: a charge/discharge unit configured to apply a charge/discharge current to the reclassification cells; and an imaging unit configured to capture thermal images of the reclassification cells while the charge/discharge current is applied. For example, when inspecting defects occurring during the manufacturing process, the charger/discharger of the power device 110 may operate as the charge/discharge unit. Alternatively, when inspecting real-time defects of the battery 120 mounted in a mobility device such as an electric vehicle, a charge/discharge current may be applied to the reclassification cells using other cells different from the reclassification cells and/or an electric vehicle motor.

According to an embodiment, the controller 132 may be configured to diagnose a state of a reclassification cell in which a heat spot is detected in the thermal image among the reclassification cells as a defective state. The imaging unit may include a thermal imaging camera, and based on the thermal imaging camera image, it may be determined whether heat spots occur in the reclassification cells due to the charge/discharge current.

According to an embodiment, the controller 132 may be configured to perform thermal test on false positive (FP) suspected cells among the battery cells that belong to a range between a lower limit value of the reclassification range and the classification reference value. The reclassification range may have an upper limit value and a lower limit value, and the classification reference value may be positioned between the upper limit value and the lower limit value. A battery cell that belongs to the range between the lower limit value of the reclassification range and the classification reference value may be classified as a normal cell, but in the case of cells positioned close to the classification reference value, it may be an FP cell that is actually a defective cell but is incorrectly classified as a normal cell. Cells that belong to the range between the lower limit value of the reclassification range and the classification reference value may be defined as FP suspected cells, and reclassification through thermal test may be performed on the FP suspected cells. Classification errors may be reduced through reclassification of the FP suspected cells. According to an embodiment, a thermal test may be performed on FN suspected cells that belong to a range between the upper limit value of the reclassification range and the classification reference value, and through this, FN cells that are actually normal cells but are incorrectly classified as defective cells may be detected.

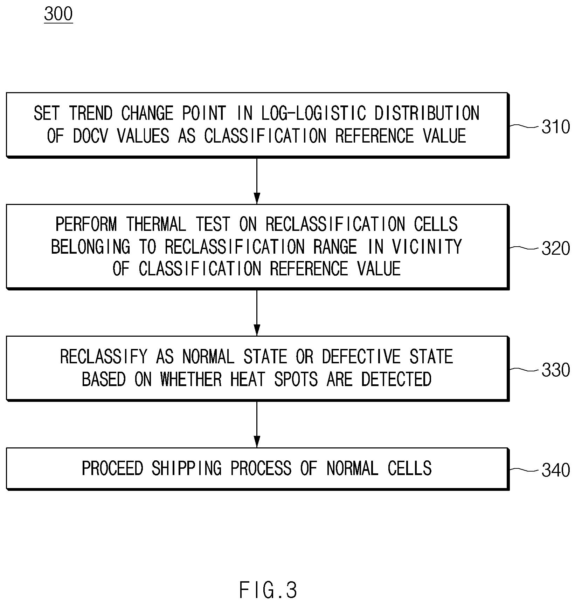

FIG. 3 illustrates a process of reclassifying reclassification cells located in the vicinity of a classification reference value based on a thermal test according to some embodiments.

Referring to FIG. 3, a flow 300 illustrating a process of reclassifying reclassification cells located in the vicinity of a classification reference value based on thermal test may be shown.

When the classification reference value is set in a step 310, a thermal test may be additionally performed in a step 320 on the reclassification cells belonging to the reclassification range. For example, a thermal test may be performed on FP suspected cells within the range between the lower limit of the reclassification range and the classification reference value and/or FN suspected cells within the range between the upper limit of the reclassification range and the classification reference value.

In a step 330, the battery management device 130 may analyze a thermal camera image to detect whether thermal spots are detected and may reclassify cells having thermal spots as defective cells and reclassify cells having no thermal spots as normal cells. In a step 340, when inspecting defects during the manufacturing process, defective cells may be transferred to procedures such as disposal and analysis, and normal cells may be transferred to shipping procedures. Alternatively, when inspecting defects while cells are mounted in a mobility device such as an electric vehicle, controls such as performance limitations or output limitations may be performed on the defective cells, and notifications or warnings regarding the defective cells may be provided to the user's registered terminal.

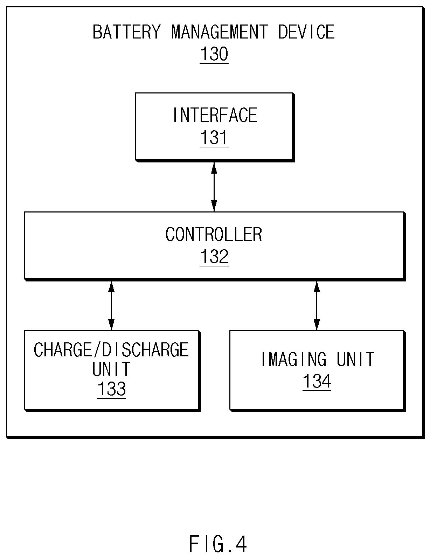

FIG. 4 illustrates a battery management device further including a charge/discharge unit and an imaging unit according to some embodiments.

Referring to FIG. 4, a battery management device 130 may further include a charge/discharge unit 133 and an imaging unit 134.

When inspecting defects during the manufacturing process, the charge/discharge unit 133 may be a charge/discharge device provided for charge/discharge testing of manufactured cells. When inspecting defects during operation after being mounted on an electric vehicle or the like, the charge/discharge unit 133 may be a normal cell different from the cell to be re-inspected, or an electric vehicle motor or the like. The imaging unit 134 may include a thermal imaging camera. The imaging unit 134 may be installed to capture images of battery cells during the cell manufacturing process, or may be installed in a form capable of capturing images of battery cells during operation of cells mounted on an electric vehicle or the like.

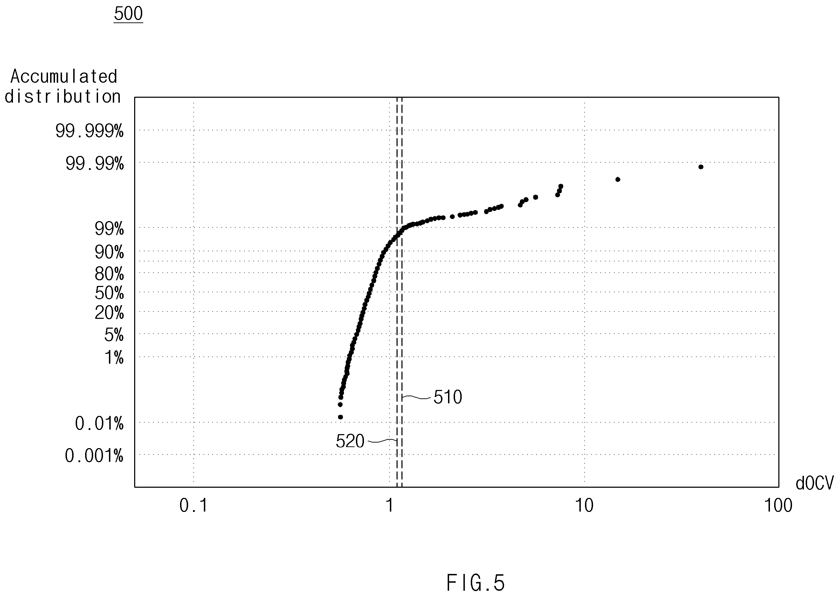

FIG. 5 illustrates a method for classifying states of battery cells using a classification reference value that is set based on a distribution of OCV difference values according to some embodiments.

Referring to FIG. 5, a graph 500 illustrating a method for classifying the states of battery cells using a classification reference value set based on the distribution of OCV difference values may be shown.

The graph 500 may represent a log-logistic distribution for the OCV difference values of the battery cells. For example, in the graph 500, the horizontal axis may represent the logarithmic value of the OCV difference value (dOCV), and the vertical axis may represent the cumulative distribution of the battery cells in a range from 0% to 100%.

In the log-logistic distribution of the graph 500, a characteristic point may be selected based on the variation of the OCV difference value (dOCV) slope. A characteristic point may be selected based on trend changes in the dOCV slope. For example, a characteristic point may be selected from a part where an early-stage slope transitions to a later-stage slope.

The characteristic point may be handled as a classification reference value 510. Cells having a dOCV higher than the classification reference value 510 may be primarily classified as defective cells. For example, as shown, approximately 1% of the cumulative number of manufactured cells, battery cells constituting electric vehicle battery packs, ESS, and the like may be classified as primary defective cells.

A range of approximately 5% before and after the classification reference value 510 may be set as a reclassification range. For example, for a classification reference value 510 of 1.16 mV, a range of 1.11 mV to 1.21 mV may be set as a reclassification range. According to an embodiment, the reclassification range may be newly set for each inspection based on the manufacturing environment of the battery cells or the operating environment of cells mounted in electric vehicles.

A range between the classification reference value 510 and the lower limit value 520 of the reclassification range may include FP suspected cells that are actually defective cells but are classified as normal cells. Additional thermal testing may be performed on the FP suspected cells, and classification accuracy may be improved based thereon.

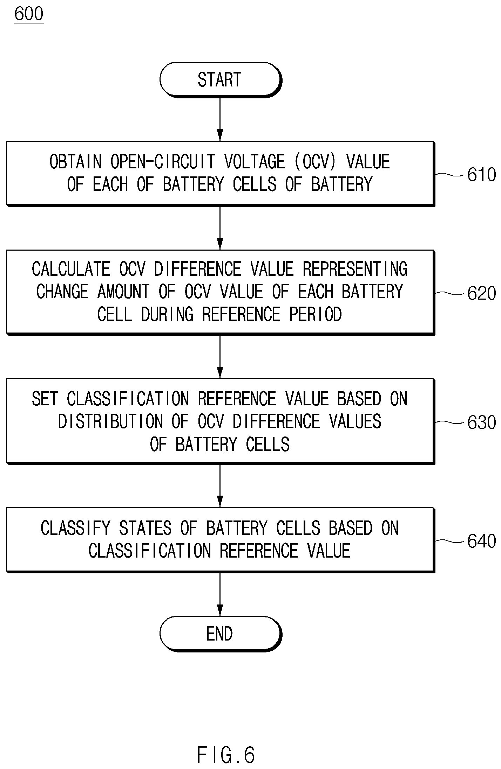

FIG. 6 illustrates steps of configuring a battery management method according to some embodiments.

Referring to FIG. 6, the battery management method 600 may include steps 610 to 640. However, the method is not limited thereto, and some steps may be omitted or other general steps may be added, and the steps of the battery management method 600 may be carried out in an order different from that is shown.

The battery management method 600 may include steps that are processed chronologically in the battery management device 130. Therefore, even when omitted below, the above-described explanation of the battery management device 130 may equally apply to the battery management method 600.

Steps 610 to 640 of the battery management method 600 may be performed by the interface 131 and controller 132 of the battery management device 130.

In Step 610, the battery management device 130 may perform a step of obtaining an OCV value of each of battery cells of a battery.

In Step 620, the battery management device 130 may perform a step of calculating an OCV difference value representing a change amount of the OCV value of each battery cell during a reference period.

In Step 630, the battery management device 130 may perform a step of setting a classification reference value based on a distribution of the OCV difference value of the battery cells.

In Step 640, the battery management device 130 may perform a step of classifying states of the battery cells based on the classification reference value.

According to an embodiment, the battery management method 600 may be implemented in the form of a computer program stored on a computer-readable storage medium. In other words, the computer program may include instructions for implementing the battery management method 600, and the instructions of the program may be stored on a computer-readable storage media.

According to an embodiment, the computer-readable storage medium may include a hardware device specially configured to store and execute computer program instructions such as hard disks, floppy disks, and magnetic tapes, optical media such as CD-ROMs, DVDs, magneto-optical media such as floptical disks, and ROMs, RAMs, flash memory, and the like. Computer program instructions may include a machine language code generated by a compiler and a high-level programming language code that may be executed by a computer using an interpreter or the like.

Terms such as "comprise," "include," or "have," as used in the foregoing should be construed, unless expressly stated otherwise, as meaning that they may incorporate such components, and may therefore be interpreted as including other components, not excluding other components. Unless otherwise defined, all terms, including technical and scientific terms used herein, have the same meaning as generally understood by one of ordinary skill in the art to which the present invention pertains. Terms, such as those defined in commonly used dictionaries, should be interpreted as having a meaning that is consistent with their meaning in the context of the relevant art and are not interpreted in an idealized or overly formal sense unless explicitly defined in the present invention.

The above descriptions are merely examples of the technical ideas disclosed in this document, and a person with common knowledge in the technical field to which the embodiments disclosed in this document pertain will be able to make various modifications and variations to the extent that they do not depart from the essential characteristics of the embodiments disclosed in this text. Therefore, the embodiments disclosed in this document are intended not to limit the technical ideas disclosed in this document but to illustrate, and the scope of the technical ideas disclosed in this document is not limited by such embodiments. The scope of protection of technical ideas disclosed in this document shall be construed to the extent of the claims below, and all technical ideas within the equivalent extent shall be construed as being included in the scope of rights of this document.

## Claims

1. A battery management device comprising:
an interface configured to obtain an open- circuit voltage (OCV) value of each of battery cells of a battery; and
a controller configured to calculate an OCV difference value representing a change amount of the OCV value of each battery cell during a reference period, to set a classification reference value based on a distribution of the OCV difference values of the battery cells, and to classify states of the battery cells based on the classification reference value.

2. The device of claim 1, wherein the controller is configured to select a characteristic point based on variation of an OCV difference value slope in the distribution of the OCV difference values, and to set the OCV difference value corresponding to the characteristic point as the classification reference value.

3. The device of claim 2, wherein the characteristic point includes an inflection point where a sign of a slope of the OCV difference value changes from positive to negative or from negative to positive.

4. The device of claim 2, wherein the distribution of the OCV difference values includes a log-logistic distribution of the OCV difference values.

5. The device of claim 1, wherein the controller is configured to perform a thermal test on reclassification cells among the battery cells that belong to a reclassification range including the classification reference value and to classify a state of the reclassification cells based on a result of the thermal test.

6. The device of claim 5, further comprising:
a charge/discharge unit configured to apply a charge/discharge current to the reclassification cells; and
an imaging unit configured to capture thermal images of the reclassification cells while the charge/discharge current is applied.

7. The device of claim 5, wherein the controller is configured to diagnose a state of a reclassification cell among the reclassification cells in which a heat spot is detected in the thermal image as a faulty state.

8. The device of claim 5, wherein the controller is configured to perform the thermal test on false positive (FP) suspected cells among the battery cells that belong to a range between a lower limit value of the reclassification range and the classification reference value.

9. A battery management method comprising:
a step of obtaining an open-circuit voltage (OCV) value of each of battery cells of a battery;
a step of calculating an OCV difference value representing a change amount of the OCV value of each battery cell during a reference period;
a step of setting a classification reference value based on a distribution of the OCV difference value of the battery cells; and
a step of classifying states of the battery cells based on the classification reference value.

10. The method of claim 9, wherein the step of setting the classification reference value includes:
a step of selecting a characteristic point based on variation of an OCV difference value slope in the distribution of the OCV difference values; and
a step of setting an OCV difference value corresponding to the characteristic point as the classification reference value.

11. The method of claim 10, wherein the characteristic point includes an inflection point where a sign of a slope of the OCV difference value changes from positive to negative or from negative to positive.

12. The method of claim 10, wherein the distribution of the OCV difference values includes a log-logistic distribution of the OCV difference values.

13. The method of claim 9, further comprising:
a step of performing a thermal test on reclassification cells among the battery cells that belong to a reclassification range including the classification reference value; and
a step of classifying a state of the reclassification cells based on a result of the thermal test.

14. The method of claim 9, wherein the step of performing the thermal test includes:
a step of applying a charge/discharge current to the reclassification cells through a charge/discharge unit; and
a step of capturing thermal images of the reclassification cells through an imaging unit while the charge-discharge current is applied.

15. The method of claim 13, wherein the step of classifying the state of the reclassification cells includes a step of diagnosing a state of a reclassification cell among the reclassification cells in which a heat spot is detected in the thermal image as a faulty state.

16. The method according to claim 13, wherein the step of performing the thermal test includes a step of performing the thermal test on false positive (FP) suspected cells among the battery cells that belong to a range between a lower limit value of the reclassification range and the classification reference value.
